Europäisches Patentamt

European Patent Office

Office européen des brevets

(19)

(11) Veröffentlichungsnummer: **0 205 768 B1**

# (12) EUROPÄISCHE PATENTSCHRIFT

(45) Veröffentlichungstag der Patentschrift: **10.07.91**

(51) Int. Cl.5: **G12B 9/02**

(21) Anmeldenummer: **86103831.3**

(22) Anmeldetag: **20.03.86**

(54) **Messgerätegehäuse.**

(30) Priorität: **13.04.85 DE 3513345**

(43) Veröffentlichungstag der Anmeldung:
**30.12.86 Patentblatt 86/52**

(45) Bekanntmachung des Hinweises auf die
Patenterteilung:
**10.07.91 Patentblatt 91/28**

(84) Benannte Vertragsstaaten:
**DE FR GB IT NL SE**

(56) Entgegenhaltungen:
**EP-A- 0 100 949        DE-A- 2 843 221**
**FR-A- 2 532 434        GB-A- 2 005 037**
**US-A- 3 518 538        US-A- 3 609 545**
**US-A- 3 946 613**

(73) Patentinhaber: **Asea Brown Boveri Aktienge-**
**sellschaft**
**Kallstadter Strasse 1**
**W-6800 Mannheim-Käfertal(DE)**

(72) Erfinder: **Hochreuther, Karl**
**Hersbrucker Strasse 98**
**W-8500 Nürnberg(DE)**

(74) Vertreter: **Rupprecht, Klaus, Dipl.-Ing. et al**
**c/o BBC Brown Boveri Aktiengesellschaft**
**ZPT Postfach 100351 Kallstadter Strasse 1**
**W-6800 Mannheim 1(DE)**

**Beschreibung**

Die Erfindung betrifft ein Meßgerätegehäuse der im Oberbegriff des Anspruchs 1 genannten Art.

Übliche Meßgeräte sind bezüglich ihres Aufbaus als Tischgeräte konzipiert. Das auf eine Ablagefläche gestellte Meßgerät ist über zwei Meßleitungen mit Meßspitzen oder -sonden verbunden, die der Messende bei der Untersuchung eines Meßobjektes in der Hand hält. zum Umschalten, z.B. des Meßbereichschalters muß gewöhnlich mindestens eine Hand zur Bedienung frei sein.

Bei Prüfungsarbeiten im Anlagenbereich steht oft keine geeignete Ablagefläche für das Meßgerät zur Verfügung. Man hat deshalb hierfür Meßgeräte entwickelt, die von einem um den Hals gehängten Traggurt gehalten werden. Doch auch in diesem Fall werden beide Hände für die beiden Meßspitzen oder -sonden benötigt, wodurch eine Bedienung des Meßgerätes erschwert ist.

Weiterhin gibt es zwar miniaturisierte Meßgeräte, die unmittelbar in die Meßsonde eingebaut und somit zusammen mit dieser in der Hand gehalten werden. Diese Geräte sind jedoch für anspruchsvolle Prüfaufgaben mit hohen Spannungen oder großen Strömen nicht geeignet. Außerdem ist eine miniaturisierte Anzeige für manche Anwendungen ausgesprochen unerwünscht.

Aus der US-A-3 518 538 ist ein kellenförmiges Meßgerät bekannt, das aus zwei zusammenfügbaren Gehäuseschalen besteht, die von einem stielförmigen Halteteil in einen tellerförmigen Anzeigeteil übergehen. Die Bedienelemente des Meßgerätes sind im Schwenkbereich eines Daumens angeordnet, der zu einer den Halteteil von hinten umfassenden Hand gehört. Es handelt sich somit um ein ergonomisch vorteilhaft aufgebautes Gerät, bei dem allerdings keine Mittel vorgesehen sind, die im Ruhezustand des Gerätes eine Befestigung der Meßsonden an diesem ermöglichen. Da bei Testgeräten dieser Art die Meßsonden über Kabel fest mit dem Gerät verbunden sind, besteht auch nicht die Möglichkeit die Meßsonden getrennt vom Geräte aufzuräumen.

Eine Möglichkeit, die Meßsonde am Meßgerät zu befestigen, ist aus der US-A-3 946 613 bekannt. Bei diesem Gerät ist auf der Rückseite des Gehäuses eine entsprechende Haltevorrichtung angeordnet. Abgesehen davon, daß das Meßgerät nicht die ergonomischen Vorteile des vorbeschriebenen Gerätes aus der US-A-3 518 538 besitzt, würde eine Befestigungsvorrichtung auf der Gehäuserückseite das Halten des Gerätes in einer Hand sehr unbequem machen.

Aufgabe der Erfindung ist es, ein Meßgerätegehäuse zu schaffen, das bequem in einer Hand gehalten werden kann und mit derselben Hand bedienbar ist, und an dem eine Befestigungsvorrichtung für Meßsonden vorgesehen ist, die beim Halten des Meßgerätes nicht stört und vorhandene Freiräume nutzt.

Diese Aufgabe wird durch die im Anspruch 1 gekennzeichneten Merkmale gelöst. Zweckmäßige Ausgestaltungen und Weiterbildungen des Erfindungsgegenstandes sind in den Unteransprüchen genannt.

Durch die kellenartige Gestaltung des Gehäuses erhält man einen Anzeigeteil, der bezüglich seiner Größe üblichen Tischgeräten nicht nachsteht. Gleichzeitig kann dabei der stielförmige Halteteil aufgrund seiner Abmessungen durch eine Hand bequem von hinten erfaßt werden, ohne daß dabei Teile der Hand die Sicht auf Bedien- oder Anzeigeteile behindern. Allein durch Schwenkbewegungen des Daumens ist es möglich, voneinander unabhängige Bedienelemente zu betätigen. An mindestens einer Seite des Halteteils ist eine Meßsonde lösbar befestigt. Dabei wird der Umstand genutzt, daß der Anzeigeteil über den Halteteil hinausragt. Somit ermöglicht eine im Anzeigeteil vorgesehene Aussparung in Verbindung mit einer am Halteteil angebrachten Haltegabel das Einrasten einer mit dem Meßgerät verbundenen Meßsonde.

Die Haltegabel ist so angebracht, daß sie das bequeme Halten des Meßgerätes in der Hand nicht beeinträchtigt. Außerdem findet die Meßsonde in dem freien Raum zwischen dem Anzeigeteil und der Haltegabel eine günstige Unterbringung.

Im Ruhezustand bilden Meßsonde und Meßgerät eine geschlossene Einheit, von der nur das Verbindungskabel beweglich in einem Bogen herabhängt.

In vorteilhafter Weiterbildung des Erfindungsgegenstandes kann der Gebrauchswert des Meßgerätes dadurch erhöht werden, daß das Gehäuse einen sicheren Staubschutz bietet und andererseits eine bequeme Bedienung des Meßgerätes dadurch gewährleistet ist, daß der Meßbereichsschalter als ein die Bedienfläche überragendes Schaltrad und eine daneben angeordnete Schaltwippe im Schwenkbereich des Daumens liegen.

Für Meßgeräte zur Überprüfung von Netzleitungen verwendet man eine Sonde, die an einen Netzstecker angepaßt ist und somit beide Pole einschließlich dem Schutzkontakt beinhaltet. Besitzt die Meßsonde jedoch nur einen Pol, dann ist es von erheblichem Vorteil, am freien Ende des Anzeigeteils in Richtung der Längserstreckung des Halteteils eine Meßspitze am Gehäuse zu befestigen, die den zweiten Pol bildet.

Wichtig ist, daß zur Verminderung der Kosten ein im Grundaufbau gleichbleibendes Gehäuse an verschiedene Meßgerätearten angepaßt werden kann. Hierzu sind die Gehäuseschalen am freien Ende des Halteteils offen und in die Öffnung zwischen den Gehäuseschalen ist ein austauschbares Verschlußteil eingesetzt, das durch in Nuten eingreifende Nasen oder Stege gehalten wird. Es ist zweckmäßig die Haltegabel materialeinheitlich am Verschlußteil anzuformen.

Da zu unterschiedlichen Meßgeräten auch unterschiedliche Meßsonden gehören, ist es erforderlich, Verschlußteile mit Haltegabeln unterschiedlicher Größe herzustellen. Die Verschlußteile können sich weiterhin dadurch unterscheiden, daß es solche gibt, die als Gehäuseansatz ausgebildet sind. Ein solcher Gehäuseansatz eignet sich insbesondere zur Aufnahme von Batterien, die wiederum nur für bestimmte Meßgerätearten benötigt werden.

Unterschiedliche Meßsonden haben auch unterschiedlich große Kontaktteile, die ihrerseits wieder unterschiedlich große Aussparungen benötigen, um der Meßsonde einen festen Halt zu geben. Zur Beherrschung dieser Variante ist als Aussparung im Anzeigeteil eine Haltetasche vorgesehen, die zwischen den Gehäuseschalen eingepaßt ist und gegen Haltetaschen unterschiedlicher Größe ausgetauscht werden kann.

Da die Meßspitze bei zweipoligen Meßsonden entfällt, wird die verbleibende Öffnung durch eine zwischen die Gehäuseschalen einlegbare Abdeckung geschlossen.

Damit das Gehäuse sicherer in der Hand liegt, ist die untere Gehäuseschale im Handbereich aufgerauht oder mit Griffnoppen versehen.

Ein Ausführungsbeispiel der Erfindung wird im folgenden näher beschrieben und ist in den Zeichnungen dargestellt.

Es zeigen:

Figur 1: Das Gehäuse in Anwendung bei einem Prüfgerät für Fehlerstromschutzschalter, mit einer als Schutzkontaktstecker ausgeführten Meßsonde in Draufsicht.

Figur 2: Das Gehäuse nach Figur 1 mit Blick auf das Verschlußteil.

Figur 3: Das Gehäuse in Anwendung bei einem Prüfgerät für Isolationswiderstände mit einer am Gehäuse festen und einer über ein Verbindungskabel beweglichen Meßspitze in Draufsicht.

Figur 4: Die obere Gehäuseschale

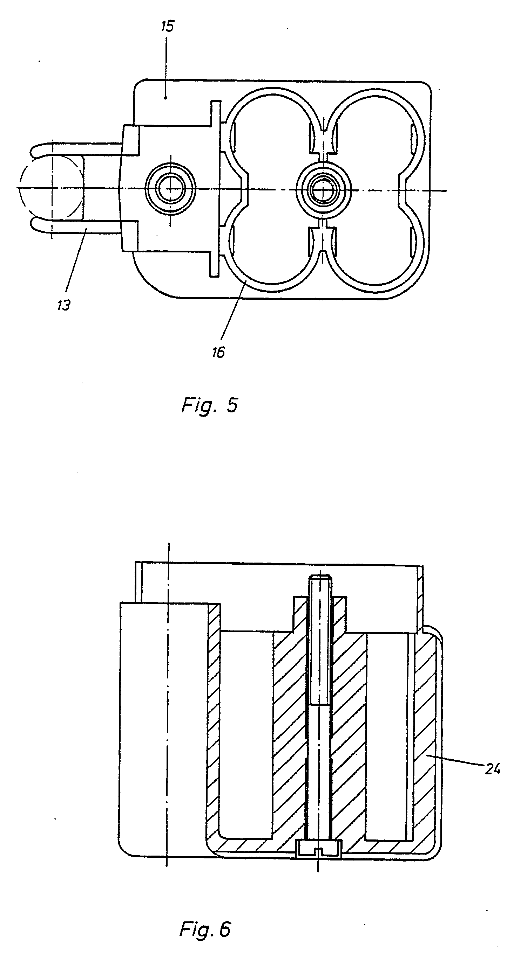

Figur 5: Ein Verschlußteil mit Gehäuseansatz

Figur 6: Eine Kappe für den Gehäuseansatz

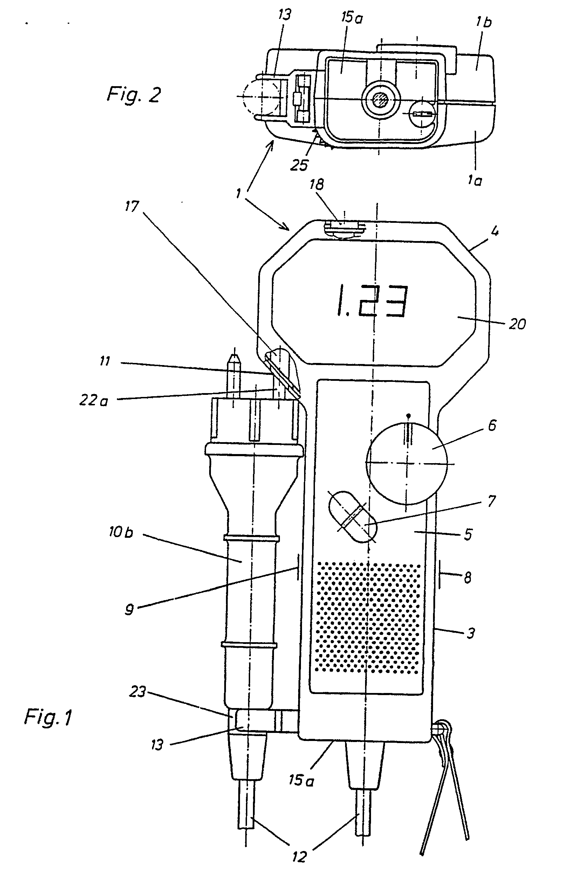

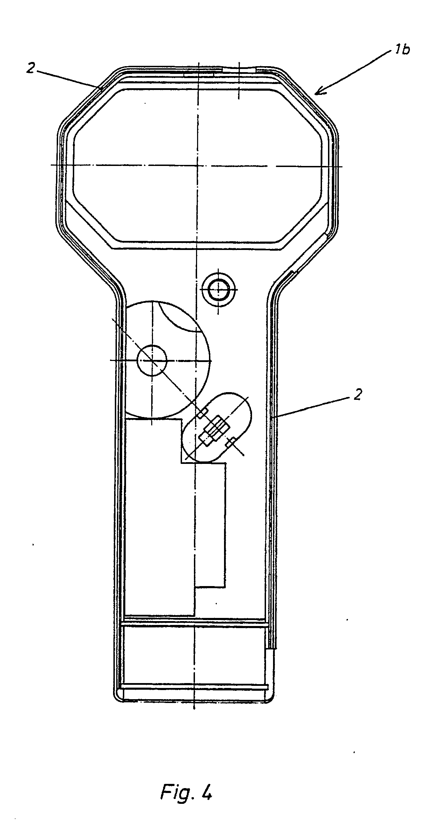

Wie die Figuren 2 und 4 zeigen, besteht das Gehäuse 1 aus einer unteren Gehäuseschale 1a und einer oberen Gehäuseschale 1b. Die untere Gehäuseschale 1a wird im Bereich ihrer Stoßkante von einer Nut eingerahmt, die auf ihrer Innenseite durch eine überhöhte Staubschutzkante 2 begrenzt wird. Die obere Gehäuseschale 1b besitzt ebenfalls eine Staubschutzkante, die beim Zusammensetzen der beiden Gehäuseschalen 1a, 1b in die Nut eingreift. Durch das Überlappen der Staubschutzkanten ergibt sich ein labyrinthartiger Staubschutz.

Das Gehäuse 1 besitzt eine kellen- oder löffelartige Form und läßt sich in einen Halteteil 3 und einen Anzeigeteil 4 gliedern. Der Anzeigeteil 4 kann je nach Bedarf mit einem digitalen Display 20 oder einem Analogmeßwerk 21 versehen werden. In beiden Fällen läßt sich das Anzeigefeld ausreichend groß gestalten.

Am Halteteil 3 sind im Bereich der Bedienfläche 5 ein Schaltrad 6 für den Meßbereichsschalter und eine Schaltwippe 7 für einen Umschalter vorgesehen. Die Anordnung der beiden Bedienelemente 6, 7 wurde in Abstimmung auf die Abmessungen des Halteteils 3 so gewählt, daß sie im Schwenkbereich eines Daumens liegen, der zu einer rechten Hand gehört, die das Halteteil 3 von hinten erfaßt. Zur bequemen Betätigung des Schaltrades 6 überragt dieses auf der "Daumenseite" 8 des Gehäuses 1 den Halteteil 3.

Der "Daumenseite" 8 gegenüberliegend auf der "Fingerseite" 9 des Gehäuses 1 ist in dem den Halteteil 3 überragenden Teil des Anzeigeteils 4 eine Aussparung 11 vorgesehen, in die das Kontaktteil 22 der Meßsonde 10 eingesteckt werden kann. Eine am freien Ende des Halteteils 3 befestigte Haltegabel 13 erfaßt die Meßsonde im Bereich ihres isolierenden Handstücks 23. Nachdem der Kontaktteil 22 in die Aussparung 11 eingesteckt wurde, genügt ein leichter Druck, damit das Handstück 23 in der Haltegabel 13 einrastet.

Ein sich spiralförmig zusammenziehendes Verbindungskabel 12 verbindet die Meßsonde 10 mit dem Gehäuse 1 in einem relativ engen Bogen, so daß eine Gefährdung durch frei herabhängende Meßleitungen ausscheidet.

Von wesentlicher Bedeutung für die konstruktive Detailgestaltung des Gehäuses 1 war das Ziel mit den gleichen Gehäuseschalen 1a, 1b verschiedene Gehäusevarianten für unterschiedliche Meßgeräte zu realisieren. Um einen möglichst leichten Austausch der variablen Teile zu erreichen, werden diese jeweils zwischen die beiden Gehäuseschalen 1a, 1b, also im Bereich der Trennfuge eingesetzt und über Nuten und Zungen am Gehäuse 1 verankert.

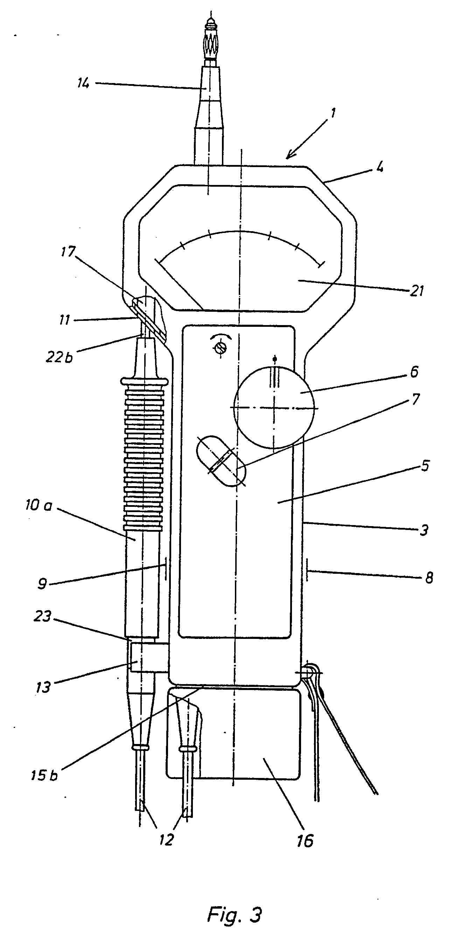

Ein erstes variables Teil dieser Art ist eine fest mit dem Gehäuse zu verbindende Meßspitze 14, die jeweils in Verbindung mit solchen Meß- oder Prüfgeräten benötigt wird, deren Meßsonde 10a, wie in Figur 3 dargestellt, nur einpolig gestaltet ist. Bei Geräten dieser Art gelingt es nur mit Hilfe dieser gehäusefesten Meßspitze 14, gleichzeitig das Meßgerät in einer Hand zu halten, dabei die Bedienelemente 6, 7 zu betätigen, und auch noch einen elektrischen Kontakt mit dem Meßobjekt herzustellen. Wird eine mehrpolige Meßsonde 10b, wie in Figur 1 dargestellt, benötigt, so entfällt die Meßspitze 14 und das verbleibende Loch wird durch eine Abdeckung 18 geschlossen.

Ein weiteres variables Teil ist ein Verschlußteil 15, das die am freien Ende des Halteteils 3 in den beiden Gehäuseschalen 1a, 1b ausgesparte Öffnung schließt. Das ebenfalls durch ineinandergreifende Nuten und Stege oder Zungen am Gehäuse befestigte Verschlußteil 15 hat zunächst die Aufgabe, die materialeinheitlich angeformte Haltegabel 13 zu tragen. Da die Haltegabel 13 unterschiedliche Meßsonden 10a, 10b erfassen muß, wird auch sie mit unterschiedlichen Abmessungen hergestellt und kann durch unterschiedliche Verschlußteile 15a, 15b leicht ausgetauscht werden.

Um den relativ knapp bemessenen Raum des Gehäuses 1 zu erweitern, übernimmt das Verschlußteil 15 eine weitere Funktion in Form eines Gehäuseansatzes 16. Z.B. bei Meßgeräten mit Batterieversorgung kann der Gehäuseansatz 16 die Batterien aufnehmen. Zum Wechseln der Batterien wird eine Kappe 24 des Gehäuseansatzes 16 vom Verschlußteil 15 gelöst.

Da auch die Kontaktteile 22a, 22b der Meßsonden 10a, 10b variieren, muß die Größe der im Anzeigeteil 4 vorgesehenen Aussparung 11 variabel sein. Hierzu wird eine entsprechend angepaßte Haltetasche 17 zwischen die beiden Gehäuseschalen 1a, 1b eingefügt.

Die Rückseite des Gehäuses 1 ist mit rändelartigen Griffnoppen 25 versehen, so daß das Gehäuse rutschsicher in der Hand liegt.

**Ansprüche**

1. Meßgerätegehäuse, das aus zwei Gehäuseschalen (1a,1b) besteht, die kellenartig so geformt sind, daß sie von einem stielförmigen Halteteil (3) in einen breiteren tellerförmigen Anzeigeteil (4) übergehen und die Bedienelemente (6,7) des Meßgerätes, die vorzugsweise am Halteteil (3) angeordnet sind, im Schwenkbereich eines Daumens liegen, der zu einer den Halteteil (3) von hinten erfassenden Hand gehört, dadurch gekennzeichnet, daß in dem den Halteteil (3) überragenden Bereich des Anzeigeteils (4) eine Aussparung (11) vorgesehen ist, in die eine durch ein Kabel (12) mit dem Meßgerät verbundene Meßsonde (10) mit ihrem freien, durch einen Kontaktteil (22) gebildeten Ende einsteckbar ist und an dem dem Anzeigeteil (4) gegenüberliegenden Ende des Halteteils (3) eine Haltegabel (13) vorgesehen ist, die die Meßsonde im Bereich ihres isolierenden Handstücks (23) erfaßt, und daß das Handstück (23) bei Ausübung eines leichten Druckes in der Haltegabel (13) einrastet.

2. Meßgerätegehäuse nach Anspruch 1, dadurch gekennzeichnet, daß die beiden Gehäuseschalen (1a,1b) über Staubschutzkanten (2) ineinandergreifen und ein einseitig eine Bedienfläche (5) überragendes Schaltrad (6), ebenso wie ein daneben angeordnetes weiteres Bedienelement, vorzugsweise eine Schaltwippe (7), im Schwenkbereich des Daumens liegen.

3. Meßgerätegehäuse nach einem der vorhergehenden Ansprüche, dadurch gekennzeichnet, daß das Verbindungskabel (12) spiralförmig ausgebildet ist und am freien Ende des Halteteils (3) in diesen eingeführt ist, so daß es bei vertikal aufgerichtetem Halteteil (3) zwischen diesem und der Meßsonde (10) bogenartig herabhängt.

4. Meßgerätegehäuse nach einem der vorhergehenden Ansprüche, dadurch gekennzeichnet, daß am freien Ende des Anzeigeteils (4) in Richtung der Längserstreckung des Halteteils (3) eine Meßspitze (14) am Gehäuse (1) befestigt ist, die bei einer einpoligen Meßsonde (10a) den zweiten Pol bildet.

5. Meßgerätegehäuse nach einem der vorhergehenden Ansprüche, dadurch gekennzeichnet, daß die Gehäuseschalen (1a,1b) am freien Ende des Halteteils (3) offen sind und in die Öffnung zwischen die Gehäuseschalen (1a,1b) ein austauschbares Verschlußteil (15) eingesetzt ist, das durch in Nuten eingesetzte Nasen oder Stege gehalten ist.

6. Meßgerätegehäuse nach einem der vorhergehenden Ansprüche, dadurch gekennzeichnet, daß die Haltegabel (13) materialeinheitlich am Verschlußteil (15) angeformt ist.

7. Meßgerätegehäuse nach einem der vorhergehenden Ansprüche, dadurch gekennzeichnet, daß Verschlußteile (15) mit einer Haltegabel (13) unterschiedlicher Größe ausgebildet sind und Verschlußteile (15) einen Gehäuseansatz (16) bilden, der sich vorzugsweise zur Aufnahme von Batterien eignet.

8. Meßgerätegehäuse nach einem der vorhergehenden Ansprüche, dadurch gekennzeichnet, daß als Aussparung (11) zur Aufnahme des freien Endes der Meßsonde (10) im Anzeigeteil (4) eine Haltetasche (17) zwischen den Gehäuseschalen (1a,1b) eingepaßt ist, die gegen Haltetaschen (17) unterschiedlicher Größe austauschbar ist.

9. Meßgerätegehäuse nach einem der vorhergehenden Ansprüche, dadurch gekennzeichnet, daß die Meßspitze (14) bei zweipoligen Meßsonden (10b) entfällt und die verbleibende Öffnung durch eine zwischen die Gehäuseschalen (1a,1b) einlegbare Abdeckung (18) geschlossen ist.

10. Meßgerätegehäuse nach einem der vorhergehenden Ansprüche, dadurch gekennzeichnet, daß an der unteren Gehäuseschale (1a) der Handbereich aufgerauht oder mit Griffnoppen (25) versehen ist.

## Claims

1. Measuring-instrument housing which consists of two housing shells (1a, 1b) which are shaped ladle-like in such a way that they pass from a handle-shaped holding part (3) into a wider plate-shaped indicating part (4), and the operating elements (6, 7) of the measuring instrument, which are preferably arranged on the holding part (3), lie in the pivoting area of a thumb which belongs to a hand taking hold of the holding part (3) from the rear, characterised in that a recess (11) is provided in the area of the indicating part (4) projecting beyond the holding part (3), into which recess (11) a measuring probe (10), connected by a cable (12) to the measuring instrument, can be inserted with its free end formed by a contact part (22), and a holding fork (13) is provided at the end of the holding part (3) located opposite the indicating part (4), which holding fork (13) takes hold of the measuring probe in the area of its insulating hand piece (23), and in that the hand piece (23) clicks into place in the holding fork (13) when slight pressure is exerted.

2. Measuring-instrument housing according to Claim 1, characterised in that the two housing shells (1a, 1b) interlock via dust-protection edges (2), and a switch wheel (6) projecting on one side beyond an operating surface (5) as well as a further operating element, preferably a switch rocker (7), arranged next to the switch wheel (6) lie in the pivoting area of the thumb.

3. Measuring-instrument housing according to one of the preceding claims, characterised in that the connecting cable (12) is of spiral design and is inserted into the holding part (3) at the free end of the same so that it hangs down curve-like between the holding part (3) and the measuring probe (10) when the holding part (3) is orientated vertically.

4. Measuring-instrument housing according to one of the preceding claims, characterised in that a measuring tip (14) is fastened to the housing (1) at the free end of the indicating part (4) in the direction of the longitudinal extent of the holding part (3), which measuring tip (14) forms the second pole in the case of a single-pole measuring probe (10a).

5. Measuring-instrument housing according to one of the preceding claims, characterised in that the housing shells (1a, 1b) are open at the free end of the holding part (3), and an interchangeable closure part (15) which is held by lugs or webs inserted in grooves is inserted into the opening between the housing shells (1a, 1b).

6. Measuring-instrument housing according to one of the preceding claims, characterised in that the holding fork (13) is integrally formed in one piece with the closure part (15).

7. Measuring-instrument housing according to one of the preceding claims, characterised in that closure parts (15) are designed with a holding fork (13) of different size, and closure parts (15) form a housing extension (16) which is preferably suitable for accommodating batteries.

8. Measuring-instrument housing according to one of the preceding claims, characterised in that a holding pocket (17) is fitted in between the housing shells (1a, 1b) as a recess (11) for accommodating the free end of the measuring probe (10) in the indicating part (4), which holding pocket (17) can be exchanged for holding pockets (17) of different size.

9. Measuring-instrument housing according to one of the preceding claims, characterised in that the measuring tip (14) is omitted in the case of two-pole measuring probes (10b), and the opening remaining is closed by a cover (18) which can be placed in between the housing shells (1a, 1b).

10. Measuring-instrument housing according to one of the preceding claims, characterised in that the area for the hand is roughened or provided with gripping protuberances (25) on the lower housing shell (1a).

## Revendications

1. Boîtier d'appareil de mesure composé de deux coquilles de boîtier (1a, 1b), qui ont une forme de raquette telle, qu'une partie d'affichage (4) plus large en forme de plateau se raccorde à une partie de poignée (3) en forme de manche et que les éléments de commandé (6, 7) de l'appareil de mesure, qui sont disposés de préférence sur la partie de poignée (3) sont situés dans la zone de pivotement d'un pouce, appartenant à une main qui saisit la partie de poignée (3) par l'arrière, **caractérisé** en ce qu'il est prévu, dans la zone de la partie d'affichage (4) dépassant de la partie de poignée (3), un évidement (11), dans lequel peut être engagée l'extrémité libre formée par une partie de contact (22) d'une sonde de mesure (10), reliée à l'appareil de mesure par l'intermédiaire d'un câble (12) et, à l'extrémité de la partie de poignée (3) située à l'opposé de la partie d'affichage (4), une fourche-support (13), qui saisit la sonde de mesure dans la zone de sa poignée (23) isolante, et en ce que la poignée (23) s'engage dans la fourche-support (13) en exerçant une légère pression.

2. Boîtier d'appareil de mesure selon la revendication 1, **caractérisé** en ce que les deux coquilles de boîtier (1a, 1b) s'emboîtent l'une dans l'autre par l'intermédiaire de bords anti-poussière (2) et une roue de commutation (6) formant saillie d'un seul côté sur une face d'utilisation (5) ainsi qu'un autre élément de commande disposé à proximité, de préférence un commutateur à bascule (7), sont situés dans la zone de pivotement du pouce.

3. Boîtier d'appareil de mesure selon l'une des revendications précédentes, **caractérisé** en ce que le câble de liaison (12) est enroulé en spirale et pénètre dans la partie de poignée (3) à l'extrémité libre de celle-ci, de manière telle que la partie de poignée (3) étant en position verticale, il pende en formant un arc entre la partie de poignée et la sonde de mesure (10).

4. Boîtier d'appareil de mesure selon l'une des revendications précédentes, **caractérisé** en ce qu'une touche de mesure (14) est fixée sur le boîtier (1), à l'extrémité libre de la partie d'affichage (4), dans la direction longitudinale de la partie de poignée (3), et forme le deuxième pôle dans le cas d'une sonde de mesure (10a) à un seul pôle.

5. Boîtier d'appareil de mesure selon l'une des revendications précédentes, **caractérisé** en ce que les coquilles de boîtier (1a, 1b) sont ouvertes à l'extrémité libre de la partie de poignée (3), et un élément d'obturation (15) interchangeable est monté dans l'ouverture entre les coquilles de boîtier (1a, 1b), lequel élément est maintenu par des ergots ou des pattes engagés dans des rainures.

6. Boîtier d'appareil de mesure selon l'une des revendications précédentes, **caractérisé** en ce que la fourche-support (13) est réalisée d'une seule pièce avec l'élément d'obturation (15).

7. Boîtier d'appareil de mesure selon l'une des revendications précédentes, **caractérisé** en ce que des éléments d'obturation (15) sont réalisés avec une fourchesupport (13) de dimensions différentes, et des éléments d'obturation (15) forment un prolongement de boîtier (16) qui est prévu de préférence pour recevoir des batteries.

8. Boîtier d'appareil de mesure selon l'une des revendications précédentes, **caractérisé** en ce qu'un élément de logement (17) est monté entre les coquilles de boîtier (1a, 1b) dans la partie d'affichage (4) comme évidement (11) recevant l'extrémité libre de la sonde de mesure (10), et est interchangeable avec d'autres éléments de logements (17) de dimensions différentes.

9. Boîtier d'appareil de mesure selon l'une des revendications précédentes, **caractérisé** en ce que la touche de mesure (14) est supprimée dans le cas de sondes de mesure (10b) à deux pôles et l'ouverture restante est obturée par un obturateur (18) s'engageant entre les coquilles de boîtier (1a, 1b).

10. Boîtier d'appareil de mesure selon l'une des revendications précédentes, **caractérisé** en ce que la zone de préhension de la coquille de boîtier (1a) inférieure est rugueuse ou présente des aspérités (25).

Fig. 2

Fig. 1

Fig. 3

8

*Fig. 4*

*Fig. 5*

*Fig. 6*